# EUROPEAN PATENT SPECIFICATION

(11) **EP 1 705 724 B1**
(45) Date of publication and mention of the grant of the patent: **19.08.2009**
(21) Application number: 06111701.6
(22) Date of filing: 24.03.2006
(51) Int. Cl.: H01L 41/09, H01L 41/187, B41J 2/14

(54) **Piezoelectric actator and liquid discharging device**
Piezoelektrischer Aktor und Flüssigkeitsausstossvorrichtung
Actionneur piézo-électrique et dispositif d'éjection de liquide

(30) Priority: 25.03.2005 JP 2005088390
(43) Date of publication of application: 27.09.2006
(73) Proprietor: Kyocera Corporation, Kyoto-shi Kyoto 612-8501 (JP)
(72) Inventor: Yuu, Yoshihiro, c/o Kyocera Corporation,, Kagoshima 899-4312 (JP)
(74) Representative: Eddowes, Simon

(56) References cited:
- GB-A- 2 392 550
- US-A1- 2004 113 995

## Description

### BACKGROUND OF THE INVENTION

### 1. Field of the Invention

The present invention relates to a piezoelectric actuator and a discharging device, and in particular, to a piezoelectric actuator and discharging device which are appropriate for fuel injectors, inkjet printers, piezoelectric resonators, oscillators, ultrasonic motors, ultrasonic transducers, filters, piezoelectric sensors, such as acceleration sensors, knocking sensors and AE sensors, and are appropriate for use as printing heads using, specifically, spreading vibration, extensional vibration and thickness longitudinal vibration.

### 2. Description of Related Art

Conventional products using piezoelectric ceramics include, for example, piezoelectric actuators, filters, piezoelectric resonators (including oscillators), ultrasonic transducers, ultrasonic motors, piezoelectric sensors and the like. From among these, piezoelectric actuators, for example, have a very high response speed to electrical signals in the microseconds, and therefore, are applied as piezoelectric actuators for the positioning of XY stages in semiconductor manufacturing units, piezoelectric actuators which are used for the printing head of inkjet printers and the like. In particular, recent increase in the speed of color printers, as well as reduction in price, make high the requirement of using piezoelectric actuators for discharging ink in inkjet printers and the like.

A piezoelectric element is used in such piezoelectric actuators. A so-called unimorph type piezoelectric actuator having a ceramic substrate which works as a ceramic diaphragm, and a first electrode layer, a piezoelectric layer and a second electrode layer which are provided on top of the ceramic substrate in this order, has been proposed (see, for example, No. WO02/073710)

In the above described piezoelectric actuator, the piezoelectric element (displacement element) is formed of the first electric layer and the second electric layer sandwiching the above described piezoelectric layer. In addition, zirconium oxide, aluminum oxide, magnesium oxide, aluminum nitride, silicon nitride or the like, for example, is used as the above described ceramic substrate. In order to join a displacement element to a ceramic substrate as those described above, in general, an adhesive which is hardened at a high temperature (for example, not lower than 100°C) is used.

However, the coefficient of linear thermal expansion is different between the ceramic substrate and the displacement element, and therefore, heating at the time of adhesion causes compressive stress in the displacement element, and a problem arises, such that this compressive stress significantly causes the piezoelectric properties of the displacement element to significantly deteriorate.

In order to solve the above described problem, it has been proposed to form the ceramic substrate which is used as the ceramic diaphragm of a piezoelectric material having the same composition as the piezoelectric layer which forms the displacement element (Japanese Unexamined Patent Publication No. 2004-165650 and US Patent Application No. 2004/0113995 A1).

In the piezoelectric actuator described in Japanese Unexamined Patent Publication No. 2004-165650, however, though compressive stress can be reduced, a problem arises, such that displacement becomes low when repeatedly driven. Therefore, in the case where this piezoelectric actuator is used for a liquid discharging device, for example, a problem arises, such that discharge of liquid becomes unstable.

### SUMMARY OF THE INVENTION

The present invention provides a piezoelectric actuator and a liquid discharging device which have excellent durability when driven.

The present inventors conducted diligent research in order to solve the above described problem, and as a result, discovered the following. That is to say, it is indispensable to use zonal rotational distortion in the piezoelectric material in order to gain high displacement properties. In order to gain large zonal rotational distortion in this manner, it is effective to use the composition on the rhombohedral crystal side in the vicinity of the morphotropic phase boundary (MPB) or to add a trivalent, pentavalent or higher donor component.

In the piezoelectric material having large zonal rotational distortion in this manner, however, the orientation of the crystal easily changes due to stress. Therefore, in the case where a substrate having the same composition as the piezoelectric material is used as the ceramic diaphragm in such a manner that displacement is repeatedly carried out, stress occurs in the ceramic diaphragm, and thereby, the orientation of the crystal changes. As a result, the state of binding of the piezoelectric element (displacement element) changes, and displacement is lowered.

In addition, it is preferable for the ceramic diaphragm to be made of a piezoelectric material having the same composition as the piezoelectric layer which forms the displacement element, in order to reduce thermal stress caused by the difference in the coefficient of linear thermal expansion between the ceramic diaphragm and the displacement element when these are sintered at the same time.

In order to keep both displacement and durability high, however, it is important for the second piezoelectric ceramic which carries out displacement to be a piezoelectric material having a large amount of zonal rotational component and for the first piezoelectric ceramic to be a piezoelectric material having little zonal rotation, in order to restrict the orientation of the crystal.

The piezoelectric actuator of the present invention was completed on the basis of the above described discovery, and is formed of a ceramic diaphragm made of a first piezoelectric ceramic, and a number of displacement elements which are provided on the surface of the ceramic diagram, where the displacement elements are piezoelectric actuators which are formed of a piezoelectric layer made of a second piezoelectric ceramic, as well as a common electrode and a drive electrode which sandwich this piezoelectric layer, and the above described first piezoelectric ceramic and the above described second piezoelectric ceramic have approximately the same main component and different piezoelectric properties.

In addition, in the liquid discharging device of the present invention, the above described piezoelectric actuator is joined to a flow path member having a liquid pressurizing chamber and a nozzle hole that is connected to the liquid pressurizing chamber inside, and liquid with which the above described liquid pressurizing chamber is filled is pressurized by the above described piezoelectric actuator, so that liquid drops are discharged from the above described nozzle hole.

According to the present invention, the first piezoelectric ceramic and the second piezoelectric ceramic have approximately the same main component and different piezoelectric properties, and thereby, a piezoelectric actuator and a discharging device which have excellent durability when driven can be implemented.

Here, though it is preferable for the first and second piezoelectric ceramics to be made of piezoelectric ceramics having the same composition, it is not necessary for the composition of the two to be completely identical, and the two may have different compositions, as long as the effects of the present invention can be gained, that is to say, displacement can be prevented from lowering, and excellent durability when driven can be gained.

Other objects and advantages of the present invention are clarified in the following description.

### BRIEF DESCRIPTION OF THE DRAWINGS

Fig. 1 is a schematic cross sectional diagram showing a piezoelectric actuator according to one embodiment of the present invention; and
Fig. 2(a) is a schematic cross sectional diagram showing a liquid discharging device according to one embodiment of the present invention, and Fig. 2(b) is a plan diagram thereof.

### DETAILED DESCRIPTION OF PREFERRED EMBODIMENTS

### <Piezoelectric Actuator>

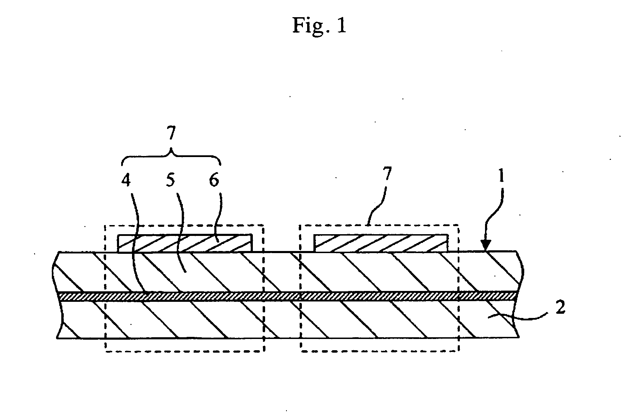

In the following, a piezoelectric actuator according to one embodiment of the present invention is described in detail in reference to the drawings. Fig. 1 is a schematic cross sectional diagram showing a piezoelectric actuator according to the present embodiment. As shown in this figure, this piezoelectric actuator 1 is provided with a number of displacement elements 7 on the surface of a ceramic diaphragm 2. Each displacement element 7 is formed of a common electrode 4, a piezoelectric layer 5 and a drive electrode 6, which are layered in this order, and thus, piezoelectric layer 5 is placed so as to be sandwiched between common electrode 4 and drive electrode 6.

Common electrode 4 is grounded, and at the same time, a voltage is applied to each drive electrode 6 from the outside. As a result, piezoelectric layer 5 is displaced due to the voltage that is applied across common electrode 4 and drive electrode 6.

In this piezoelectric actuator 1, ceramic diaphragm 2 is made of a first piezoelectric ceramic, and piezoelectric layer 5 is made of a second piezoelectric ceramic. In addition, the first piezoelectric ceramic and the second piezoelectric ceramic have approximately the same components, and are made of the materials having different piezoelectric properties. As a result, piezoelectric actuator 1 has excellent durability when driven.

Here, the above described piezoelectric ceramics mean ceramics exhibiting piezoelectric properties, and compounds in a Bi layer form, materials having a tungsten bronze structure, alkali niobate compounds having a perovskite structure, lead zirconate titanate containing Pb (PZT) and compounds containing lead titanate and having a perovskite structure can be cited as examples. From among these, lead zirconate titanate containing Pb and lead titanate are appropriate from the point of view of enhancing both wettability with and the strength of adhesiveness to electrodes.

In particular, lead titanate and barium titanate are effective in gaining a high binding strength. That is to say, it is preferable for the crystal to contain Pb as an element for forming site A, and contain Zr and/or Ti as an element for forming site B, and in particular, to be of a lead titanate zirconate based compound in order to have a high d constant and to gain a piezoelectric sintered body, which can be displaced to a great degree.

In order for the first piezoelectric ceramic and the second piezoelectric ceramic to have approximately the same main components while having different piezoelectric properties, the same main components are selected for the two in order to make the difference in the coefficient of thermal expansion small, while additives can be changed in order to make the piezoelectric properties different. In addition, by means of the same technique, the second piezoelectric ceramic can be made to form a piezoelectric material having many zonal rotational components.

It is preferable for the above described first piezoelectric ceramic and second piezoelectric ceramic to include Pb, Zr and Ti as the main components. Concretely, it is preferable to use PZT for the first piezoelectric ceramic, and to make PZT, which is the main component, contain at least one type of element selected from among Sr, Ba, Ni, Sb, Nb, Zn, Yb and Te in the second piezoelectric ceramic. As a result, a stable piezoelectric actuator 1 can be gained. Here, conversely, PZT may be used for the second piezoelectric ceramic, and at least one type of element selected from among Sr, Ba, Ni, Sb, Nb, Zn, Yb and Te may be contained in PZT, which is the main component in the first piezoelectric ceramic.

In addition, solid solutions which contain, for example, Pb (Zn_{1/3}Sb_{2/3}) O₃ and Pb (Ni_{1/2}Te_{1/2}) O₃ as subcomponents can be cited as examples.

In particular, it is desirable to further contain an alkaline earth element as an element for forming site A. Ba and Sr, for example, are preferable as the alkaline earth element from the point of view of gaining a high level of displacement, and when 0.02 mol to 0.08 mol of Ba and 0.02 mol to 0.12 mol of Sr are contained, it is advantageous to gain a great displacement in the case where the main composition is a tetragonal composition.

An example is represented by the formula Pb_{1-x-y}SrₓBa_{y} (Zn_{1/3}Sb_{2/3})ₐ (Ni_{1/2}Te_{1/2})_{b} Zr_{1-a-b-c}Ti_{c}O₃ + α wt% of Pb_{1/2}NbO₃ (0 ≤ x ≤ 0.14,0 ≤ y ≤ 0.14, 0.05 ≤ a ≤ 0.1,0.002 ≤ b ≤ 0.01, 0.44:≤ c≤ 0.50, α = 0.1 to 1.0).

It is preferable for the ratio of Zr/Ti in the first piezoelectric ceramic to be 0.96 to 0.81, for the ratio of Zr/Ti of the second piezoelectric ceramic to be 1.17 to 0.92, and for the ratio of Zr/Ti of the first piezoelectric ceramic to be smaller than the ratio of Zr/Ti in the second piezoelectric ceramic. As a result, a great binding strength can be gained.

The lattice constant ratio of c₁/a₁ in the first piezoelectric ceramic is 1.013 to 1.030, preferably 1.015 to 1.017, the lattice constant ratio of e₂/a₂ in the second piezoelectric ceramic is 1.01 to 1.016, preferably 1.011 to 1.a13, and it is preferable for the value of c₁/a₁ to be larger than the value of c_{2/}a₂. As a result, the piezoelectric layer and the thermal expansion can be made the same. Here, the above described c₁ /a₁ and c₂/a₂ can be gained, for example, by finding the ratio of the lattice constant of axis a to the lattice constant of axis c in accordance with an X-ray diffraction method (XRD) as described below.

As described above, the piezoelectric properties are different between the first and second piezoelectric ceramics, and concretely, it is preferable for the piezoelectric properties of the first piezoelectric ceramic to be not higher than 75%, and particularly, not higher than 7a% of the piezoelectric properties of the second piezoelectric ceramic. Having low piezoelectric properties means having small zonal rotations, providing piezoelectric ceramic with a high binding strength. The lower limit value of the above described piezoelectric properties is preferably not lower than 40 %. Here, the above described piezoelectric properties mean piezoelectric properties d₃₁. The piezoelectric properties d₃₁ can be found, for example, in accordance with a resonance method using an impedance analyzer as described below. Here, when the value of piezoelectric properties d₃₁ is "-," this "-" indicates the direction, and the higher the absolute value is, the better the characteristics are.

Common electrode 4 is fabricated through simultaneous sintering, and therefore, it is made of a silver-palladium alloy which contains not lower than 87 volume % of silver, preferably not lower than 90 volume %, and more preferably not lower than 93 volume %, and it is preferable to control the amount of residual stress, which occurs inside of piezoelectric actuator 1 after sintering, so as to be not higher than 100 MPa. As a result, the effects of reducing compressive stress due to the contraction of electrodes can be expected.

In order to suppress the cohesion of common electrode 4, it is preferable for the average grain diameter of common electrode 4 to be 0.1 µm to 5.0 µm.

In order to increase the strength of adhesiveness, reduce the residual stress and further stabilize piezoelectric properties d₃₁, it is preferable for common electrode 4 to include piezoelectric ceramics. These piezoelectric ceramics may be included at the ratio of 10 volume % to 60 volume % when the total amount of the silver-palladium alloy is 100 volume %, preferably 18 volume % to 50 volume %, and more preferably 20 volume % to 30 volume %. As a result, the strength of adhesiveness between common electrode 4 and piezoelectric layer 5 can be increased while the residual stress is reduced.

It is preferable for the average crystal grain diameter of the above described piezoelectric ceramics to be 0.3 µm to 1.0 µm in order to make the residual stress uniform. Furthermore, it is preferable for it to be 0.4 µm to 0.6 µm in order to suppress the defects. As a result, even in the case where residual stress occurs, the residual stress which occurs in each displacement element 7 is made uniform, and thus has a small variation, and therefore, the effects on piezoelectric properties d₃₁ are reduced.

It is preferable for the ratio of orientation of the crystal that forms the second piezoelectric ceramic before polarization to be not lower than 50% in the direction of axis a. As a result, the compressive stress that is applied to displacement elements 7 can be reduced. It is preferable for the above described ratio of orientation in axis a to be not higher than 75%. The above described orientation can be found, for example, by analyzing the crystal structure in accordance with an XRD (X-ray diffraction method).

Next, an example of a manufacturing method for piezoelectric actuator 1 is described in the case where PZT is used as the piezoelectric ceramics. First, as for the materials, a PZT powder is prepared as a powder of the first piezoelectric ceramic, and one type from among the above described PZT based materials is prepared as a powder of the second piezoelectric ceramic. Then, an appropriate organic binder is added to these piezoelectric ceramic powders, which is then formed into a tape form, and a green sheet is fabricated.

An Ag-Pd paste is applied to and layered on a portion of the fabricated green sheet as a common electrode, and a pressure of 10 MPa to 50 MPa is applied, and after that, is cut into a desired form. The binder is removed from this at approximately 400°C, and after that, it is sintered. After sintering, a desired drive electrode is formed on the surface and is polarized, and thus, a piezoelectric actuator 1, which is a layered piezoelectric body, is gained.

Here, it is preferable for the density before sintering to be not lower than 4.5 g/cm². As a result, it becomes possible to sinter at a low temperature. In the case
where the density before sintering is increased, it also becomes easy to suppress the evaporation of Pb.

### <Liquid Discharging Device>

A piezoelectric actuator of the present invention is provided with a number of displacement elements on top of one substrate (ceramic diaphragm) as described above, and therefore, can be appropriately used in a liquid discharging device. In the following, a piezoelectric actuator, which is used in a liquid discharging device according to one embodiment of the present invention, is described in detail in reference to the drawings.

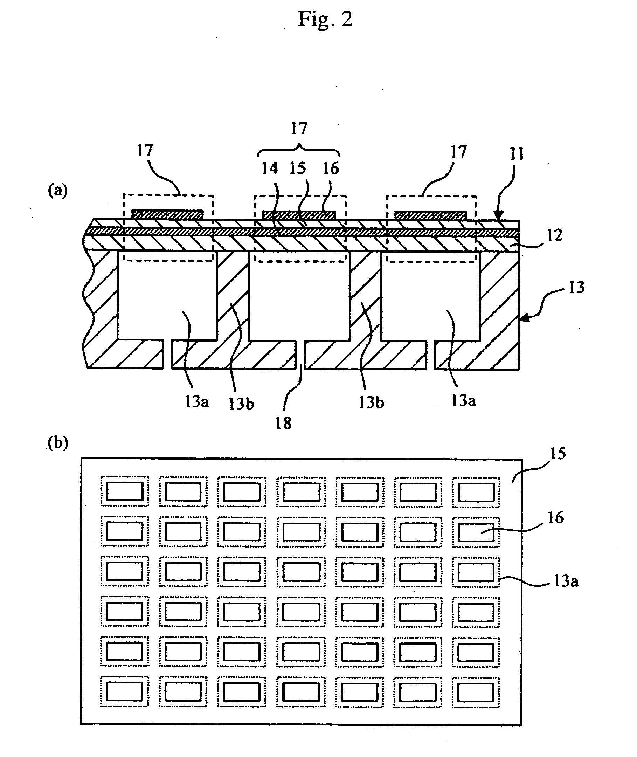

Fig. 2(a) is a schematic cross sectional diagram showing a liquid discharging device of the present embodiment, and Fig. 2(b) is a plan diagram thereof. As shown in Figs. 2(a) and 2(b), this liquid discharging device is formed by joining a piezoelectric actuator 11 to a flow path member 13. The inside of flow path member 13 is provided with liquid pressurizing chambers 13a and nozzle holes 18, which connect to liquid pressurizing chambers 13a.

In addition, pressure is applied to liquid, with which a liquid pressurizing chamber 13a is filled, by piezoelectric actuator 11 so that liquid drop are discharged from a nozzle hole 18. Such a liquid discharging device can be appropriately used as an ink jet print head which is, for example, used in a recording device having an ink jet system.

Concretely, in the piezoelectric actuator 11, a common electrode 14 and a piezoelectric layer 15 are formed on top of a ceramic diaphragm 12 in this order, and furthermore, a number of drive electrodes 16 are formed on the surface of the piezoelectric layer 15 so that a number of displacement elements 17, having a structure where the piezoelectric layer 15 is sandwiched between the common electrode 14 and a drive electrode 16, are formed on the ceramic diaphragm 12.

This piezoelectric actuator 11 is joined to the flow path member 13. In this joining, the ceramic diaphragm 12 is joined to the flow path member 13 by means of an adhesive or the like so as to close off the top portions of the liquid pressurizing chambers 13a. At this time, each of the drive electrodes 16 which form the displacement elements 17 is placed on and joined to the portion directly above a liquid pressurizing chamber 13a. Then, the liquid pressurizing chambers 13a are filled with ink.

In a state as described above, when a voltage is applied across the common electrode 14 and the drive electrode 16 by means of a drive circuit, ink is pressurized within the liquid pressurizing chamber 13a, which corresponds to the displacement element 17 that has been displaced through the application of the voltage. Then, ink drops are discharged from the nozzle hole 18 that is open at the bottom of the flow path member 13.

In the case where a piezoelectric actuator, which is a layered piezoelectric body according to the present invention, is used as a piezoelectric actuator of a print head as described above, a print head can be implemented using an inexpensive IC. Such a print head has excellent displacement properties, making possible a high speed discharge with precision, and thus, an appropriate print head for high speed printing can be provided. In addition, when such a print head is mounted on a printer, precise high speed printing can be achieved with ease by a printer having, for example, an ink tank for supplying ink to the above described print head and a mechanism for conveying a sheet of paper for recording that makes printing on a sheet of paper for recording possible, in comparison with the prior art.

Examples of the present invention will be described below. It is understood, however, that the examples are for the purpose of illustration and the invention is not to be regarded as limited to any of the specific materials or condition therein.

### EXAMPLES

In the following, the present invention is described in further detail by citing examples, but the present invention is not limited to the following examples.

### <Preparation of Piezoelectric Actuator>

First, as the material, a piezoelectric ceramic powder containing lead titanate zirconate (PZT) of a purity of not less than 99% was prepared. Then, using this piezoelectric ceramic powder, ceramic green sheets which are to become first piezoelectric ceramic and second piezoelectric ceramic, as shown in Table 1, were fabricated through sintering. Concretely, butyl methacrylate was added as a water-based binder, ammonium polycarboxylate was added as a dispersing agent, and isopropyl alcohol and pure water was respectively added to the above described piezoelectric ceramic powder as a solvent, and this was mixed so as to gain a slurry. This slurry was applied to a carrier film in accordance with a doctor blade method, and ceramic green sheets in sheet form having a thickness of 30 µm were fabricated.

The green sheets gained as in the above were used and combined as shown in Table 1, and piezoelectric actuators were fabricated. Concretely, a common electrode paste was printed on the surface of a green sheet (first piezoelectric ceramic) for a ceramic diaphragm so as to have a thickness of 4 µm, and a common electrode was formed. Furthermore, a green sheet for a piezoelectric layer (second piezoelectric ceramic) was layered on a green sheet for a ceramic diaphragm which was laid in such a manner that the side having the common electrode printed on it was facing upwards, and pressure was applied through pressing, and thus, a layered body was gained.

This layered body was degreased, and after that, held for 4 hours in an atmosphere of not less than 99% oxygen at 980°C so as to be sintered, and thus, a layered body having a piezoelectric layer 5, a ceramic diaphragm 2 and a common electrode 4 as shown in Fig. 1 was fabricated. Next, drive electrodes 6 were formed on the surface of the piezoelectric layer 5, in the following manner. That is to say, first, Au paste was applied through screen printing. This was sintered in a normal atmosphere at 600°C to 800°C, so that the drive electrodes 6 were formed.

Finally, leads were connected to drive electrodes 6 through soldering, and thus, a piezoelectric actuator as that shown in Fig. 1 was gained (samples No.1 to 12 in Table 1).

The lattice constant ratio c/a and the piezoelectric constant d₃₁, which indicate the properties of a piezoelectric actuator, were respectively measured in the following manner. The results of measurement are shown in Table 1.

### (Lattice Constant Ratio c/a)

The lattice constant ratio c/a of each piezoelectric ceramic layer was gained by finding the ratio of the lattice constant in axis a and the lattice constant in axis c through XRD.

### (Piezoelectric Constant d₃₁)

Au was vapor deposited on the front and rear surfaces of the above described layered body (after sintering), and this was processed to a size of 3 mm x 12 mm. Next, a direct current voltage of 4 kV/mm was applied for 1 minute via the Au electrodes on the front and rear surfaces, and thus, a polarizing process was carried out. d₃₁ of this sample was found in accordance with a resonance method using an impedance analyzer.

### <Evaluation>

Durability when driven was evaluated for each piezoelectric actuator gained in the above. The evaluation method is shown in the following, and the results are shown in Table 1.

### (Evaluation Method)

Each piezoelectric actuator was processed to a size of 8 mm x 8 mm, and thus, test pieces were fabricated. Next, each test piece was made to adhere to a metal substrate having an outer form of 10 mm x 10 mm with a hole of 4 mm x 4 mm, and used as a sample for measuring displacement. Then, a direct current voltage of 3 kV/mm was applied for 5 minutes across the common electrode and the drive electrodes in the direction of the thickness, and thus, polarization was carried out.

Next, the samples were displaced under a voltage of 2 kV/mm. The displacement was measured using a Doppler displacement meter. After displacement was carried out for 50 hours, the displacement was measured, and the amount of deterioration in the displacement was found, and this is shown in Table 1 as "ratio of deterioration in durability (%)." Here, "displacement" in Table 1 means displacement after 30 minutes.

**Table 1**

| Sample No. | Second piezoelectric ceramic | | | | | First piezoelectric ceramic | | | | | Displacement | Ratio of deterioration in durability (%) |
|---|---|---|---|---|---|---|---|---|---|---|---|---|
| | Material | Subcomponent | c/a | Zr/Ti | d₃₁ | Material | Subcomponent | c/a | Zr/Ti | d₃₁ | | |
| | | | | | pm/V | | | | | pm/V | nm | |
| * 1 | PZT | Sr·Ba·Nb | 1.01 | 1.17 | -250 | PZT | Sr·Be·Nb | 1.01 | 1.17 | -250 | 80 | 10 |
| 2 | PZT | Sr·Ba·Nb | 1.01 | 1.17 | -220 | PZT | Sr·Ba·Nb | 1.013 | 0.95 | -180 | 78 | 5 |
| 3 | PZT | Sr·Ba·Nb | 1.01 | 1.17 | -220 | PZT | Sr·Ba·Nb | 1.017 | 0.88 | -130 | 77 | 4 |
| 4 | PZT | Sr·Ba·Nb | 1.012 | 1 | -200 | PZT | Sr·Ba·Nb | 1.016 | 0.92 | -150 | 75 | 2 |
| 5 | PZT | Sr·Ba·Nb | 1.012 | 1 | -200 | PZT | Sr·Ba·Nb | 1.02 | 0.85 | -90 | 74 | 4 |
| 6 | PZT | Sr·Ba·Nb | 1.012 | 0.95 | -180 | PZT | Sr·Ba·Nb | 1.02 | 0.85 | -90 | 70 | 4 |
| 7 | PZT | Sr·Ba·Nb | 1.016 | 0.92 | -150 | PZT | Sr·Ba·Nb | 1.025 | 0.83 | -85 | 65 | 4 |
| 8 | PZT | La·Nb | 1.013 | 0.95 | -180 | PZT | La·Nb | 1.02 | 0.85 | -90 | 70 | 4 |
| 9 | PZT | Mn·Nb | 1.013 | 0.95 | -180 | PZT | Mn·Nb | 1.02 | 0.85 | -90 | 70 | 4 |
| 10 | PZT | Sr·Ba·Nb | 1.017 | 0.88 | -130 | PZT | Sr·Ba·Nb | 1.03 | 0.81 | -80 | 60 | 5 |
| 11 | BT | Sr·Nb | 1.016 | 0.92 | -140 | BT | Sr·Nb | 1.025 | 0.83 | -80 | 55 | 5 |
| 12 | PT | Sr-Nb | 1.016 | 0.92 | -130 | PT | Sr·Nb | 1.025 | 0.83 | -75 | 53 | 4 |

| | | | | | | | | | | | | |
|---|---|---|---|---|---|---|---|---|---|---|---|---|
| Sample marked '* ' is outside the scope of the present invention. PZT: lead titanate zirconate PT: lead titanate BT : barium titanate | | | | | | | | | | | | |

As is clear from Table 1, samples No. 2 to 12 of the present invention have a displacement of not less than 53 nm, and the ratio of deterioration in durability after displacement of 50 hours was not higher than 5%.

Meanwhile, sample No. 1, where the first piezoelectric ceramic and the second piezoelectric ceramic are the same, and which is outside the scope of the present invention, had a great ratio of deterioration of not less than 10%. As a result, it can be seen that samples No. 2 to 12 of the present invention have excellent durability when driven.

It is further understood by those skilled in the art that the foregoing description is a preferred embodiment of the disclosed piezoelectric actuator and discharging device and that various changes and modifications may be made in the invention without departing from the scope of the claims.

## Claims

1. A piezoelectric actuator (1;11) comprising: a ceramic diaphragm (2;12) made of a first piezoelectric ceramic; and a number of displacement elements (7;17) which are provided on a surface of the ceramic diaphragm, each displacement element being formed of a piezoelectric layers (5;15) made of a second piezoelectric ceramic as well as a common electrode (4;14) and a drive electrode (6;16) which sandwich this piezoelectric layer, **characterised in that**
said first piezoelectric ceramic and said second piezoelectric ceramic have substantially the same main components and different piezoelectric properties.

2. The piezoelectric actuator according to Claim 1, wherein the piezoelectric properties of said first piezoelectric ceramic are not higher than 75% of the piezoelectric properties of said second piezoelectric ceramic.

3. The piezoelectric actuator according to Claim 1, wherein said first piezoelectric ceramic and second piezoelectric ceramic include Pb, Zr and Ti as main components.

4. The piezoelectric actuator according to Claim 3, wherein said first piezoelectric ceramic and second piezoelectric ceramic contain lead titanate zirconate as a main component, and the second piezoelectric ceramic contains at least one type of element selected from the group consisting of Sr, Ba, Ni, Sb, Nb, Zn, Yb and Te.

5. The piezoelectric actuator according to Claim 1, wherein the lattice constant ratio of c_{1/}a₁ of said first piezoelectric ceramic is 1.013 to 1.030, the lattice constant ratio of c₂/a₂ of said second piezoelectric ceramic is 1.01 to 1.016 and the value of c_{1/}a₁ is larger than the value of c₂/a₂.

6. The piezoelectric actuator according to Claim 1, wherein the ratio of Zr/Ti in said first piezoelectric ceramic is 0.96 to 0.81, the ratio of Zr/Ti in said second piezoelectric ceramic is 1.17 to 0.92 and the ratio of Zr/Ti in said first piezoelectric ceramic is smaller than the ratio of Zr/Ti in said second piezoelectric ceramic.

7. The piezoelectric actuator according to Claim 1, wherein the ratio of orientation of the crystal that forms said second piezoelectric ceramic before polarization, is not lower than 50% in the direction of axis a.

8. A liquid discharging device, comprising a flow path member (13) of which the inside is provided with a liquid pressurizing chamber (13a) and a nozzle hole (18) that connects to the liquid pressurizing chamber, and a piezoelectric actuator (11) according to claim 1 joined to the flow path member, wherein liquid, with which the liquid pressurizing chamber is filled, is pressurized by means of said piezoelectric actuator so that a liquid drop can be discharged from said nozzle hole.

## Patentansprüche

1. Piezoelektrischer Aktuator (1; 11), umfassend:
eine keramische Membran (2; 12) aus einer ersten piozoelektrischen Keramik; und eine Anzahl von Verlagerungselementen (7; 17), die auf einer Oberfläche der keramischen Membran vorgesehen sind, wobei jedes Verlagerungselement aus einer piezoelektrischen Schicht (5; 15) gebildet wird, die aus einer zweiten piezoelektrischen Keramik gefertigt ist, sowie eine gemeinsame Elektrode (4; 14) und eine Antriebselektrode (6; 16), welche diese piezoelektrische Schicht umgeben, **dadurch gekennzeichnet, dass**
die erste piezoelektrische Keramik und die zweite piezoelektrische Keramik im Wesentlichen die gleichen Bestandteile und unterschiedliche piezoelektrische Eigenschaften aufweisen.

2. Piezoelektrischer Aktuator nach Anspruch 1, wobei die piezoelektrischen Eigenschaften der ersten piezoelektrischen Keramik nicht höher als 75 % der piezoelektrischen Eigenschaften der zweiten piezoelektrischen Keramik ist.

3. Piezoelektrischer Aktuator nach Anspruch 1, wobei die erste piezoelektrische Keramik und die zweite piezoelektrische Keramik Pb, Zr und Ti als Hauptbestandteile umfassen.

4. Piezoelektrischer Aktuator nach Anspruch 3, wobei die erste piezoelektrische Keramik und die zweite piezoelektrische Keramik Blei-Zirkonat-Titonat als Hauptbestandteil enthalten, und die zweite piezoelektrische Keramik zumindest eine Art von Element, ausgewählt aus der Gruppe bestehend aus Sr, Ba, Ni, Sb, Nb, Zn, Yb und Te, enthält.

5. Piezaefektrischer Aktuator nach Anspruch 1, wobei das Gitterkonstantenverhältnis c₁/a₁ der ersten piezoelektrischen Keramik 1,013 bis 1,030 beträgt, das Gitterkonstantenverhältnis c₂/a₂ der zweiten piezoelektrischen Keramik 1,01 bis 1,016 beträgt, und der Wert von c₁/a₁ größer als der Wert von c₂/a₂ ist.

6. Piezoelektrischer Aktuator nach Anspruch 1, wobei das Verhältnis von Zr/Ti in der ersten piezoelektrischen Keramik 0,96 bis 0,81 beträgt, das Verhältnis von Zr/Ti in der zweiten piezoelektrischen Keramik 1,17 bis 0,92 beträgt und das Verhältnis von Zr/Ti in der ersten piezoelektrischen Keramik kleiner als das Verhältnis von Zr/Ti in der zweiten piezoelektrischen Keramik ist.

7. Piezoelektrischer Aktuator nach Anspruch 1, wobei das Ausrichtungsverhältnis des Kristalls, der die zweite piezoelektrische Keramik bildet, vor der Polarisation nicht geringer als 50 % in der Richtung der Achse a ist.

8. Flüssigkeitsausstoßvorrichtung, umfassend ein Durchflusspfadelement (13), dessen Innenseite mit einer Flüssigkeitsdruckbeaufschlagungskammer (13a) und einem Düsenloch (18), das mit der Flüssigkeitsdruckbeaufschlagungskammer verbunden ist, versehen ist, und einen piezoelektrischen Aktuator (11) nach Anspruch 1, der mit dem Durchflusspfadelement verbunden ist, wobei Flüssigkeit, mit der die Flüssigkeitsdruckbeaufschlagungskammer gefüllt ist, mittels des piezoelektrischen Aktuators mit Druck beaufschlagt wird, so dass ein Flüssigkeitstropfen aus dem Düsenloch ausgestoßen werden können.

## Revendications

1. Actionneur piézoélectrique (1 ; 11) comprenant :
un diaphragme en céramique (2 ; 12) composé d'une première céramique piézoélectrique ; et un certain nombre d'éléments de déplacement (7 ; 17) qui sont fournis sur une surface du diaphragme en céramique,
chaque élément de déplacement étant formé d'une couche piézoélectrique (5 ; 15) composée d'une seconde céramique piézoélectrique ainsi que d'une électrode commune (4 ; 14) et d'une électrode de commande (6 ; 16) qui prennent en sandwich cette couche piézoélectrique,
**caractérisé en ce que**
ladite première céramique pièzoélectrique et ladite seconde céramique piézoélectrique sont sensiblement composées des mêmes composants principaux et possèdent des propriétés piézoélectriques différentes.

2. Actionneur piézoélectrique selon la revendication 1, dans lequel les propriétés piézoélectriques de ladite première céramique piézoélectrique ne dépassent pas 75 % des propriétés piézoélectriques de ladite seconde céramique piézoélectrique.

3. Actionneur piézoélectrique selon la revendication 1, dans lequel ladite première céramique piézoélectrique et ladite seconde céramique piézoélectrique comprennent du Pb, du Zr et du Ti en tant que composants principaux.

4. Actionneur piézoélectrique selon la revendication 3, dans lequel ladite première céramique piézoélectrique et ladite seconde céramique piézoélectrique contiennent du zirconate titanate de plomb en tant que composant principal, et la seconde céramique piézoélectrique contient au moins un type d'élément choisi dans le groupe constitué par Sr, Ba, Ni, Sb, Nb, Zn, Yb et Te.

5. Actionneur piézoélectrique selon la revendication 1, dans lequel le rapport des constantes de réseau c₁/a₁ de ladite première céramique piézoélectrique est de 1,013 à 1,030, le rapport des constantes de réseau c₂/a₂ de ladite seconde céramique piézoélectrique est de 1,01 à 1,016 et la valeur de c₁/a₁ est supérieure à la valeur de c₂/a₂.

6. Actionneur piézoélectrique selon la revendication 1, dans lequel le rapport Zr/Ti dans ladite première céramique piézoélectrique est de 0,96 à 0,81, le rapport Zr/Ti dans ladite seconde céramique piézoélectrique est de 1,17 à 0,92 et le rapport Zr/Ti dans ladite première céramique piézoélectrique est inférieur au rapport Zr/Ti dans ladite seconde céramique piézoélectrique.

7. Actionneur piézoélectrique selon la revendication 1, dans lequel le rapport de l'orientation du cristal formant ladite seconde céramique piézoélectrique avant polarisation n'est pas inférieur à 50 % dans la direction de l'axe a.

8. Dispositif d'éjection de liquide, comprenant un élément de voie de passage (13) dont l'intérieur est pourvu d'une chambre de pressurisation de liquide (13a) et d'un orifice de buse (18) qui est relié à la chambre de pressurisation de liquide, et d'un actionneur piézoélectrique (11) selon la revendication 1 raccordé à l'élément de voie de passage, dans lequel le liquide avec lequel la chambre de pressurisation de liquide est remplie est mis sous pression au moyen dudit actionneur piézoélectrique, de sorte qu'une goutte de liquide peut être éjectée par ledit orifice de buse.
